# EUROPEAN PATENT APPLICATION

(11) **EP 1 460 778 A2**
(43) Date of publication of application: **22.09.2004**
(21) Application number: 04250976.0
(22) Date of filing: 23.02.2004
(51) Int. Cl.: H04B 7/005

(54) **Transmit power control**

(30) Priority: 07.03.2003 GB 0305295
(71) Applicant: Ubinetics Limited, Melbourn, Hertfordshire SG8 6DP (GB)
(72) Inventor: Parker, Nicholas Ubinetics Limited, Hertfordshire, SG8 6DP (GB)
(74) Representative: Wardle, Callum Tarn

(57) **Abstract**

A power controller uses both a stored power calibration table to set the gain control 4 of a transmission amplifier 6 over a portion of the total power range of the transmitter, whilst a detector is used over only a small portion of the power range to provide a more accurate reported value of the transmission signal power, the more accurate value being used to determine when the maximum permitted transmission signal power has been reached.

## Description

The present invention relates to apparatus and a method for power control in a wireless transmitter.

In the field of wireless communications, and in particular mobile telephony, various standards have been applied governing various parameters and applying limits to those parameters that must be adhered to by manufacturers and operators within the particular field. One such parameter is the power of the transmitted signal from a mobile telecommunications device. For example, in the 3GPP specifications governing the mobile telecommunication standard generally referred to as 3G, limits are stipulated on the maximum power permitted of transmitted signal, together with a minimum accuracy of reported signal power between steps in transmitted signal power.

Consequently, manufacturers of wireless telecommunication apparatus need to ensure that their equipment is capable of controlling the transmitted signal power within the requirements dictated by the appropriate standards.

For example a handset must be able to control its transmit power level over a wide range, e.g. -50dBm to +24dBm for a class 3 handset, and to a tight tolerance. Limits are set on the absolute accuracy of the transmitted power level, the step accuracy, i.e. the accuracy between steps in power level, and the reported power accuracy. These various limit definitions have in the past lead to complex methods being employed for transmit gain control and calibration. These methods require a lengthy calibration procedure or a lot of baseband interaction with the RF (radio frequency) section of the handset. This is detrimental because not only does the complexity inevitably result in increased unit costs for the handset, but the relatively high level of baseband interaction is undesirable.

According to a first aspect of the present invention there is provided a power control apparatus for a wireless transmitter, comprising a power controller arranged to control the power level of a transmitted signal over a predetermined power range and a power detector arranged to detect the power level of the transmitted signal over only a first portion of the power range, wherein the power controller is arranged to control the power of the transmitted signal over the first portion of the power range in accordance with the detected power levels.

Preferably, the power control apparatus further comprises a data storage device in which a power calibration table is stored, wherein the power controller is arranged to control the power of the transmitted signal over a second portion of the power range in accordance with the power calibration table.

Additionally or alternatively, the power controller is inhibited from increasing the power of the transmitted signal above a predetermined and maximum value.

Additionally, when the transmitted signal is within the first portion of the power range, the power controller may be arranged to determine the power level of the transmitted signal from the output of the power detector.

Additionally, the power controller may be arranged to receive a transmission power demand signal specifying an increase in signal power and, when the power of the transmitted signal is within the first portion of the power range, to add to the current signal power level provided by the power detector the demanded increase in signal power level and, if the product exceeds the predetermined maximum power level, to restrict the transmitted signal power to the maximum power level.

Additionally or alternatively, on receipt of a predetermined control signal the power controller may be arranged to set the transmitted signal power according to the power calibration table to within a predetermined extent of the maximum power level irrespective of the detected power level.

Additionally or alternatively the power controller may be arranged to provide a reported transmission signal power value, the reported power value being determined from the detector output when the transmitted signal power is within the first portion of the power range and being determined from the power calibration table when the transmitted signal power is within the second portion of the power range.

Additionally, the accuracy of the reported power value determined from the detector output is preferably greater than that determined from the power calibration tables.

Additionally or alternatively, the first portion of the power range may be substantially smaller than the remainder of the power range.

Preferably the power control apparatus according to the first aspect of the present invention is included within a wireless telecommunication handset.

According to a second aspect of the present invention there is provided a method of controlling transmission power for a wireless transmitter over a predetermined power range, the method comprising detecting the power level of a transmitted signal over only a first portion of the power range and controlling the power level of the transmitted signal in accordance with the detected power level.

Additionally, the power level of the transmitted signal is preferably controlled over a second portion of the power range in accordance with a stored power calibration table.

Additionally or alternatively, the power of the transmitted signal may be inhibited from being increased above a predetermined maximum power level.

Additionally, when the power of the transmitted signal is within the first portion of the power range, in response to receiving a power demand signal specifying an increase in the power level of the transmitted signal, the detected power level and the demanded increase in power level may be added together and, if the product of the addition exceeds the predetermined maximum power level, the power level of the transmitted signal is set and the maximum power value.

Additionally or alternatively, the method may further comprise setting the power level of the transmitted signal according to the power calibration table to within a predetermined extent of the maximum power value, in response to a predetermined control signal.

Additionally or alternatively, the method may further comprise providing a reported power level value of the transmitted signal, the reported power level value being derived from the detected power level of the transmitted signal when the power level of the transmitted signal is within the first portion of the power range and being derived from the power calibration table when the power level of the transmitted signal is within the second portion of the power range.

Additionally, the accuracy of the reported power level value derived from the detected power level of the transmitted signal may be greater than that derived from the power calibration table.

An embodiment of the present invention will be described hereinafter, by way of illustrative example only, with reference to the accompanying figures, of which:

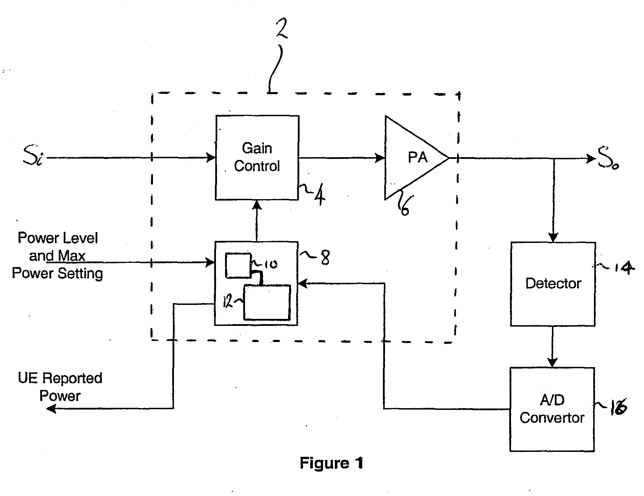

Figure 1 schematically illustrates power control apparatus according to an embodiment of the present invention.

Figure 1 shows a block diagram implementation of an embodiment of the present invention. The signal to be transmitted Sᵢ is input to a power controller 2. The power controller includes a gain control unit 4 that controls power amplification of the signal Sᵢ applied by a power amplifier 6. The input signal received by the gain control unit 4 is subsequently input to the power amplifier 6 which outputs the final output signal Sₒ at the final transmitted signal power level. Also included in the power controller 2 is a command unit 8 comprising a data processor 10 and a data storage unit 12. The data storage unit 12 stores both a main calibration table having a number of output values to be output to the gain control unit 4 in order to provide a desired power level of the transmitted signal Sₒ. The desired power level is input to the command unit 8 and is received by the data processor 10, which accesses the main calibration table, as will be explained in more detail below to retrieve the appropriate output value to be output to the gain control unit 4.

The transmitted output signal Sₒ is also input to a signal power detector 14 that detects the actual transmitted power of the output signal. The detector 14 outputs the power level as an analogue value to an analogue to digital converter 16, which in turn passes the transmitted power level as a digital signal to the command unit 8 within the power controller 2 where it is stored as a second calibration table in the data storage unit 12. The command unit 8 also provides a further output indicating the actual transmitted power level as received from the detector 14 and analogue to digital converter 16.

The power amplifier 6 is such that the transmitted signal Sₒ can be transmitted over a relatively wide power range, for example -50dBm to +24dBm. With the exception of the proportion of this power range, for example the top 10dB, the signal transmission power is controlled using open loop control. The requested power level is received at the command unit 8 of the power controller 2, and in particular is received by the processor 10. The processor 10 is arranged to access the main calibration table to determine the output value to be output to the gain control unit 4 that will cause the amplifier 6 to output the transmitted signal at the desired power level. The control elements within the gain control unit 4 are calibrated in 1dB steps and operate over a sufficient range to take into account temperature, frequency and process variations. For example, if such variations amount to 10dB, and the transmission power level can be between -50dBm and +24dBm, then a minimum of 84 steps are required. The entire transmission apparatus, of which the power control apparatus shown in Figure 1 is a part, is calibrated at a single frequency and at room temperature to an absolute accuracy of +/-6dB and a linearity of +/- 20%. This accuracy is sufficient for open loop power control and the step accuracy requirement stipulated by the appropriate standards. Therefore, when the transmitter is operated under open loop power control, the transmission power is stepped up and down according to the main calibration table.

The main calibration table has sufficient linearity to be able to maintain the step accuracy required but not however, the maximum power accuracy. Therefore, for an upper portion of the power range, for example the top 10dB, the control apparatus operates in a closed loop manner. The actual transmitted signal power is detected by the detector 14 and input, via the A to D converter 16, to the command unit 8. The detector has an accuracy of +/-1.0dB when measuring maximum power, as compared to the accuracy operating under open loop control of +/-6dB. In operation, when the signal transmission power is within the power detector's range it provides a signal reporting the actual signal power to the command unit 8. Due to the reported signal's improved accuracy over that of the main calibration table there may well be a discrepancy between the detected signal power and the current power setting provided by the main calibration table. However, in practice this is not an issue as it is only the maximum permitted power level that is of interest. Hence the command unit 8 merely switches to the power signal reported by detector 14 to determine by how much the gain control unit 4 can be increased, regardless of the supposed signal power that the increase would result in according to the main calibration table.

For example, suppose by means of the main calibration the requested power demand has resulted in a signal power level that according to the main calibration table equates to a signal power of +20dBm. As previously stated the maximum permitted signal power may be +24dBm. Thus, according to the main calibration table only a further +4dBm is permitted. However, at this power level the detector 14 is operative and reports a transmitted signal power of, say, +17dBm. Therefore the command unit 8 will permit a further power increase of +7dBm. The fact that such an increase equates to a power setting in the main calibration table of +27dBm is irrelevant.

When the detector 14 is active the reported power is taken from the stored table generated by the detector 14 output. At all other times the reported power is taken from the main calibration table.

When operating in the upper power range for which the detector 14 is operative, when the signal transmission power reaches the specified maximum power level, the detector reports this to the command unit 8 that in turn inhibits any further increase in transmission power, regardless of the requested power level. If the requested power level is input in steps greater than 1dB, and the transmitted signal level is within the range of the detector, the processor 10 adds the detected power level from the detector 14 to the requested step size to check whether the next step will exceed the maximum power level. If this is the case, the step is reduced to a level that will take the transmission power to the maximum level, but now higher.

As the detector 14 is required only over the uppermost portion of the power range it is only required to have the corresponding, relatively limited, range of detection. This overcomes the difficulty in providing a detector of the required accuracy over the full power range of the transmitter. At the lower end of the detectors range the reported power value of the transmitted signal must swop from the detector table to the main calibration table. This can lead to a step change in the reported transmission power that would ordinarily violate the standardised +/-0.5dB step accuracy requirements. However, as the reported power accuracy is only specified in the standard down to 10dB below maximum power, this violation is allowed.

In some embodiments of the present invention there is one condition where the transmitter can be required to go to the maximum power level without first providing an opportunity for the detector 14 to make a measurement. This occurs during the first RACH preamble. The RACH (random access channel) is used by a wireless device to request a dedicated transmission channel from the transmission network and as such occurs before an appropriate transmission power level is determined. Consequently, the first RACH preamble can be transmitted at the maximum permitted power. If the command unit 8 receives a command associated with a RACH preamble to set the transmission level to maximum power, then according to the standardised specifications the transmitter must not exceed the maximum power level by more than 2dB. However, relying solely on the main calibration table that only has an accuracy of + or -6dBs, this upper level tolerance of +2dB cannot be met. To resolve this, the command unit 8 sets the requested power level to 4dB below the specified maximum power level under these particular conditions. This is allowed for in the 3GPP specification as this set level can be up to 9dB below that requested (12dB under extreme temperatures).

## Claims

1. Power control apparatus for a wireless transmitter, comprising:
a power controller arranged to control the power level of a transmitted signal over a predetermined power range; and
a power detector arranged to detect the power level of the transmitted signal over only a first portion of said power range, wherein said power controller is arranged to control the power of the transmitted signal over said first portion of the power range in accordance with to the detected power level.

2. Power control apparatus according to claim 1, further comprising a data storage device in which a power calibration table is stored, wherein the power controller is arranged to control the power of the transmitted signal over a second portion of the power range in accordance with the power calibration table.

3. Power control apparatus according to any preceding claim, wherein the power controller is inhibited from increasing the power of the transmitted signal above a predetermined maximum value.

4. Power control apparatus according to claim 3, wherein when the transmitted signal is within the first portion of the power range, the power controller is arranged to determine the power level of the transmitted signal from the output of the power detector.

5. Power control apparatus according to claim 4, wherein the power controller is arranged to receive a transmission power demand signal specifying an increase in signal power and, when the power of the transmitted signal is within the first portion of the power range, to add to the current signal power level provided by the power detector the demanded increase in signal power level and, if the product exceeds the predetermined maximum power level, to restrict the transmitted signal power to the maximum power level.

6. Power control apparatus according to any one of claims 3 to 5, wherein on receipt of a predetermined control signal the power controller is arranged to set the transmitted signal power according to the power calibration table to within a predetermined extent of the maximum power value irrespective of the detected power level.

7. Power control apparatus according to any one of claims 2 to 6, wherein the power controller is arranged to provide a reported transmission signal power value, the reported power value being determined from the detector output when the transmitted signal power is within the first portion of the power range and being determined from the power calibration table when the transmitted signal power is within the second portion of the power range.

8. Power control apparatus according to claim 7, wherein the accuracy of the reported power value determined from the detector output is greater than that determined from the power calibration table.

9. Power control apparatus according to any preceding claim, wherein said first portion of the power range is substantially smaller than the remainder of the power range.

10. A wireless telecommunication handset comprising power control apparatus according to any one of claims 1 to 9.

11. A method of controlling transmission power for a wireless transmitter over a predetermined power range, the method comprising:
detecting the power level of a transmitted signal over only a first portion of the power range; and
controlling the power level of the transmitted signal in accordance with the detected power level.

12. A method according to claim 11, wherein the power level of the transmitted signal is controlled over a second portion of the power range in accordance with a stored power calibration table.

13. A method according to claim 11 or 12, wherein the power of the transmitted signal is inhibited from being increased above a predetermined maximum power value.

14. A method according to claim 13, wherein when the power of the transmitted signal is within the first portion of the power range, and in response to receiving a power demand signal specifying an increase in the power level of the transmitted signal, the detected power level and the demanded increase in power level are added together and, if the product of the addition exceeds the predetermined maximum power value, the power level of the transmitted signal is set at the maximum power value.

15. A method according to any one of claims 13 or 14, wherein the method further comprises setting the power level of the transmitted signal according to the power calibration table to within a predetermined extent of the maximum power value, in response to a predetermined control signal.

16. A method according to any one of claims 12 to 15, wherein the method further comprises providing a reported power level value of the transmitted signal, the reported power level value being derived from the detected power level of the transmitted signal when the power level of the transmitted signal is within the first portion of the power range and being derived from the power calibration table when the power level of the transmitted signal is within the second portion of the power range.

17. A method according to claim 16, wherein the accuracy of the reported power level value derived from the detected power level of the transmitted signal is greater than that derived from the power calibration table.
